# EUROPEAN PATENT APPLICATION

(11) **EP 1 790 756 A1**
(43) Date of publication of application: **30.05.2007**
(21) Application number: 05768945.7
(22) Date of filing: 05.08.2005
(51) Int. Cl.: C23C 14/34, H01L 21/31

(54) **THIN-FILM FORMING APPARATUS**

(30) Priority: 05.08.2004 JP 2004229892
(71) Applicant: SHINCRON CO., LTD., Shinagawa-ku, Tokyo 140-8540 (JP)
(72) Inventor: SONG, Yizhou, 603 Hills Kawaguchi, Kawaguchi-shi, Saitama 3320026 (JP); ARAI, Tetsuji, Yokohama-shi, Kanagawa 2270036 (JP); CHIBA, Koki, Suginami-ku, Tokyo 1680063 (JP); SAKURAI, Takeshi, Yokohama-shi, Kanagawa 2230052 (JP); JIANG, Yousong, Nerima-ku, Tokyo 1790081 (JP)
(74) Representative: Grünecker, Kinkeldey, Stockmair & Schwanhäusser Anwaltssozietät
(86) International application number: PCT/JP2005/014413
(87) International publication number: WO 2006/013968

(57) **Abstract**

To provide a thin-film forming apparatus capable of forming a thin-film by bringing ions of some degree in plasma into contact with the thin-film.

This thin-film forming apparatus (1) comprises a plasma generating means (80) disposed at a position corresponding to an opening (11a) of a vacuum chamber (11) for producing plasma in the vacuum chamber (11), a base plate holder (13) for holding a substrate in the vacuum chamber (11), and an ion quenching means (90) disposed between the plasma generating means (80) and the base plate holder (13). When the plasma generating means (80) are projected directly onto the base plate holder (13), the projection image of plasma generating means (80) shielded by the ion quenching means (90) has an area smaller than the residual image of plasma generating means (80) projected onto the base plate holder (13).

## Description

### TECHNICAL FIELD

The present invention relates to a thin-film forming apparatus for producing a thin-film to be used in the fabrication of an optical thin film, optical device, device for optoelectronics, semiconductor device, etc., particularly to a thin-film forming apparatus equipped with a plasma generating means.

### BACKGROUND ART

Plasma processing which consists of ionizing a gas into a reactive gas plasma in a vacuum chamber to use the plasma for processing has been used for the formation of a thin-film on a base plate, modification of the surface of a thin-film thus formed, or etching of the surface, etc. As an example of such plasma processing, a technique has been known which consists of forming, by sputtering, a thin-film made of an incomplete reaction product of a metal on a base plate, and bringing a reactive gas plasma into contact with the thin-film, thereby producing a thin-film made of a metal compound (see, for example, Patent Document 1).

According to this technique, a plasma generating means is introduced in a thin-film forming apparatus so as to ionize a reactive gas into a plasma in a vacuum chamber. Gas converted into a plasma by a plasma generating means may comprise active species such as ions, electrons, radicals, etc.

It has been thought that a gas converted into a plasma may exert adverse effects on the formation of a thin-film depending on certain surrounding conditions. Particularly, when electrons or ions at a high energy condition (about 30 eV or higher) impinge on a base plate, they are believed to likely damage a thin-film formed there. On the other hand, radicals derived from an electrically neutral reactive gas are believed to have a favorable effect on the formation (reaction) of a thin-film. According to a conventional technique, a grid is introduced for intercepting the convergence of electrons and ions towards a base plate where a thin-film is forming, and for selectively permitting radicals to contact with a thin-film being formed on the base plate.

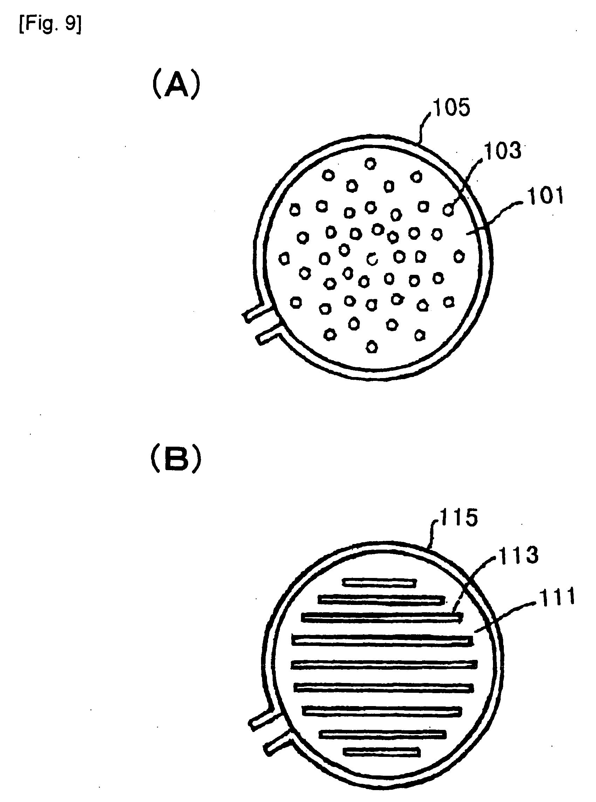

Fig. 9 illustrates the configuration of conventional grids. One grid 101 shown in Fig. 9(A) comprises a plate made of a metal or an insulating material which has, on its surface, multiple holes 103 of 0.1 to 3.0 mm in diameter. Another grid 111 shown in Fig. 9(B) comprises a plate made of a metal or an insulating material which has, on its surface, a plurality of slits 113 of 0.1 to 1.0 mm in width.

It has been possible by utilizing a grid 101 or 111 as described above to permit the selective or preferential passage of electrically neutral particles such as radicals, atoms, molecules, etc., through the grid 101 or 111 towards a reaction process zone 60, while intercepting passage of the majority of charged particles such as electrons and ions through the grid. Specifically, ions and electrons from plasma are brought into contact with the grid 101 or 111 where charge exchange takes place to electrically neutralize the electrons and ions to annihilate them. The intention of this conventional technique lies in enhancing the efficiency of plasma processing by increasing the relative density of radicals in plasma gas through quenching the majority of electrons and ions by means of a grid 101 or 111.

Patent Document 1: Japanese Unexamined Patent Application Publication No. 2001-234338, pp. 6-9, and Figs. 1, 2, 6, and 7

Despite the above fact, ions contained in a plasma derived from a gas may favorably contribute, at a considerable degree, to the formation(reaction) of a thin-film. Particularly, ions having an energy as low as 30 eV or less will favorably contribute notably to the formation(reaction) of a thin-film, since their damaging effects towards the film are marginal.

However, with a conventional grid 101 or 111 as described above, the summed areas of holes 103 or slits 113 relative to the total area of plate including the areas of holes 103 or slits 113 (aperture ratio) are comparatively small (for example, the aperture ratio of a conventional grid < 0.3). Accordingly, the majority of ions are captured by the grid 101 or 111 to be annihilated and thus ions could hardly participate in reactions which are involved in the formation of a thin-film.

In view of the problem inherent to the conventional technique, the object of the present invention is to provide a thin-film forming apparatus which enables the formation of a thin-film while enhancing the relative density of radicals in reactive gas plasma, and allowing a considerable fraction of ions in plasma to contact with a thin-film.

### DISCLOSURE OF THE INVENTION

To solve the above problem, a thin-film forming apparatus as described in Claim 1 comprises a vacuum chamber with an opening, a plasma generating means disposed at a position corresponding to the opening of the vacuum chamber for producing plasma in the vacuum chamber, a substrate holding means for holding a substrate in the vacuum chamber, and an ion quenching means disposed between the plasma generating means and the substrate holding means for quenching ions generated by the plasma generating means, wherein, when the plasma generating means are projected directly onto the base plate holder, the projection image of plasma generating means shielded by the ion quenching means has an area smaller than the residual image of plasma generating means projected onto the base plate holder.

Since the projection image of plasma generating means shielded by the ion quenching means has an area smaller than the residual image of plasma generating means projected onto the substrate holder as described above, it is possible to restrict the amount of ions to be quenched by the ion quenching means. Accordingly, it will be possible for ions which can avoid quenching by the ion quenching means to move towards the substrate holding means from the plasma generating means. Thus, it becomes possible to bring a certain fraction of ions into contact with a thin-film formed on a substrate, and to contribute to the further formation of the film.

The ion quenching means is preferably made of an electric conductor and is installed in the vacuum chamber being grounded.
This arrangement allows the quenching means to capture part of ions and electrons generated by the plasma generating means, thereby neutralizing and annihilating them.

The ion quenching means is preferably made of a hollow member.
Through this arrangement it becomes possible to pass cooling medium through a hollow member or the interior of ion quenching means, thereby suppressing elevation of the temperature of ion quenching means.

The ion quenching means is preferably made of an insulating material.
Through this arrangement, it becomes possible for the quenching means to capture part of ions generated by the plasma generating means to annihilate them.

The base plate holding means is preferably installed in the vacuum chamber being insulated from the vacuum chamber so as to float in terms of electric potential.
When the base plate holding means floats in terms of electric potential, the movement of ions generated by the plasma generating means will not be accelerated depending on the potential of base plate holding means which would otherwise occur. Thus, it becomes possible to prevent ions generated by the plasma generating means from impinging onto the base plate holding means at high energy state.

It is preferred that the plasma generating means is connected to an RF power source, comprises an antenna in the form of a planar spiral, and is supplied power not less than 2 kW but not more than 4 kW from the RF power source.
Through this arrangement it becomes possible to restrict the amount of ions and electrons of high energy derived from reactive gas by means of the plasma generating means, and to form a thin-film having a small attenuation factor.

### BRIEF DESCRIPTION OF THE DRAWINGS

Fig. 1 is a top view of a thin-film forming apparatus of the invention with cross-sections of some parts of interest.
Fig. 2 is a lateral view of the thin-film forming apparatus of the invention with cross-sections of some parts of interest.
Fig. 3 shows some parts of interest for illustrating a plasma generating means and an ion quenching means of the invention.
Fig. 4 shows some parts of interest for illustrating a plasma generating means of the invention.
Fig. 5 shows some parts of interest for illustrating an ion quenching means.
Fig. 6 shows graphs relating electric power supplied to an antenna to two optical constants of a TiO₂ thin-film.
Fig. 7 shows some parts of interest for illustrating another embodiment of the plasma generating means.
Fig. 8 shows some parts of interest for illustrating yet another embodiment of the plasma generating means.
Fig. 9 illustrates the configuration of conventional grids (ion quenching means).

### BEST MODE FOR CARRYING OUT THE INVENTION

An embodiment of the invention will be described below with reference to the attached drawings. It should be noted, however, that members and their arrangement described below are given not to limit the scope of the invention, and that various modifications will be possible without departing the scope of the invention which will be obvious to a person skilled in the art by reading through the specification.

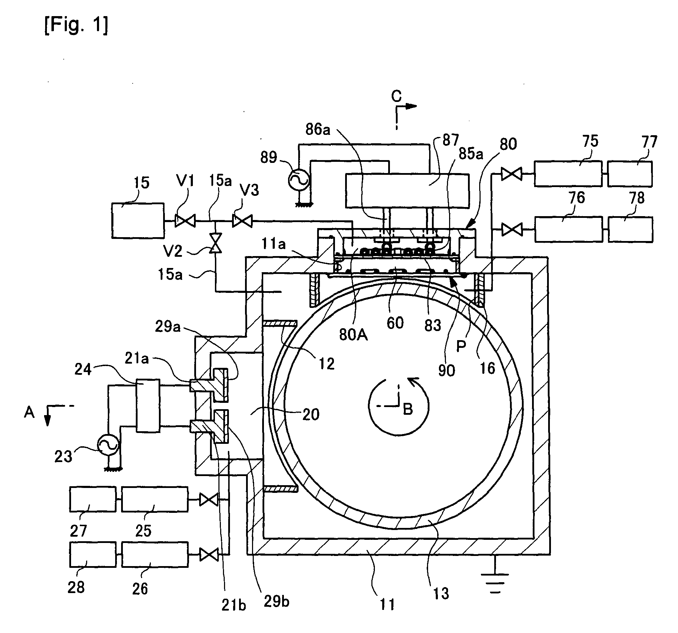

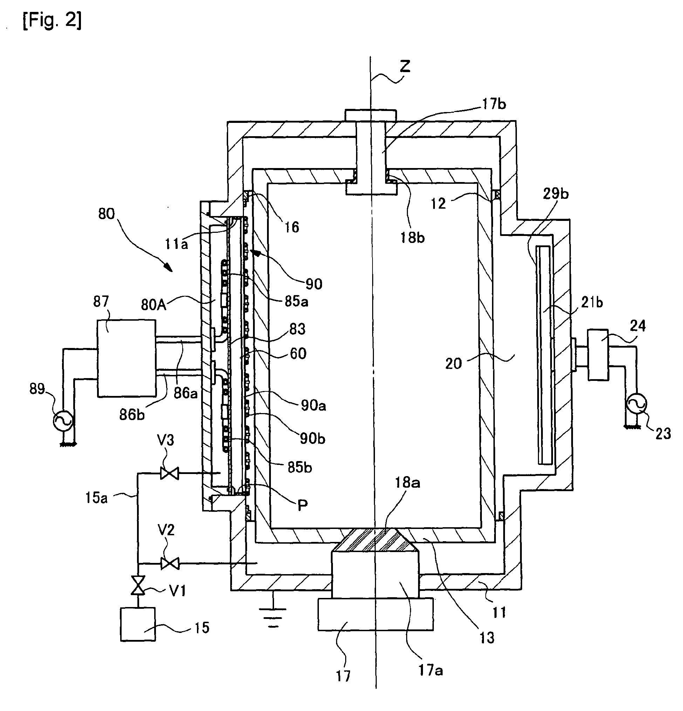

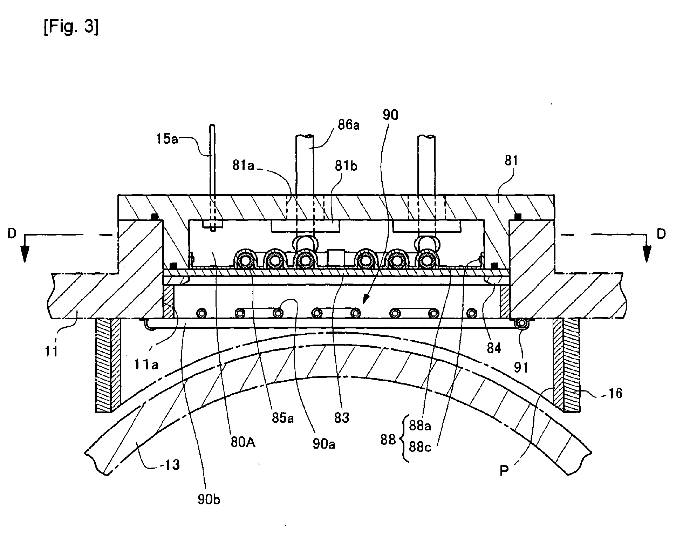

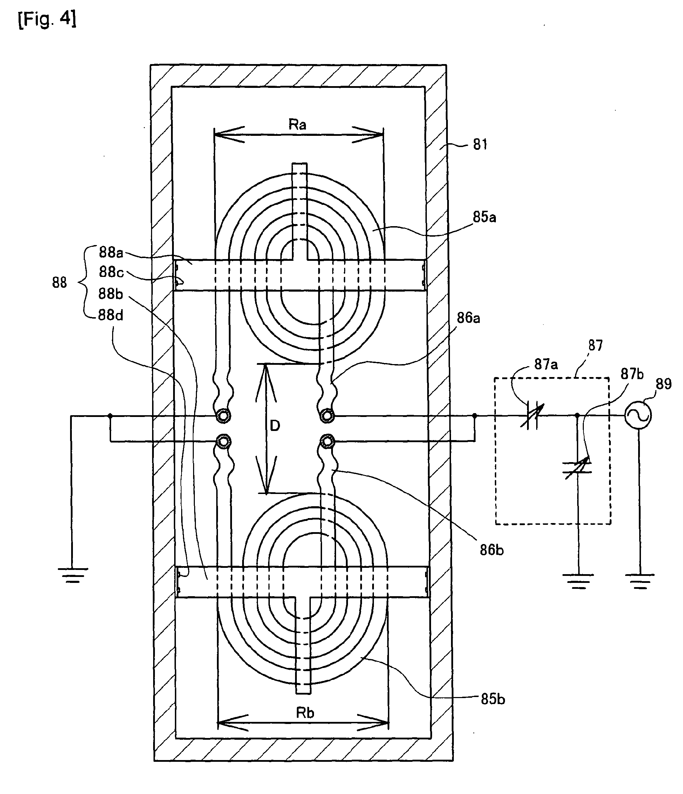

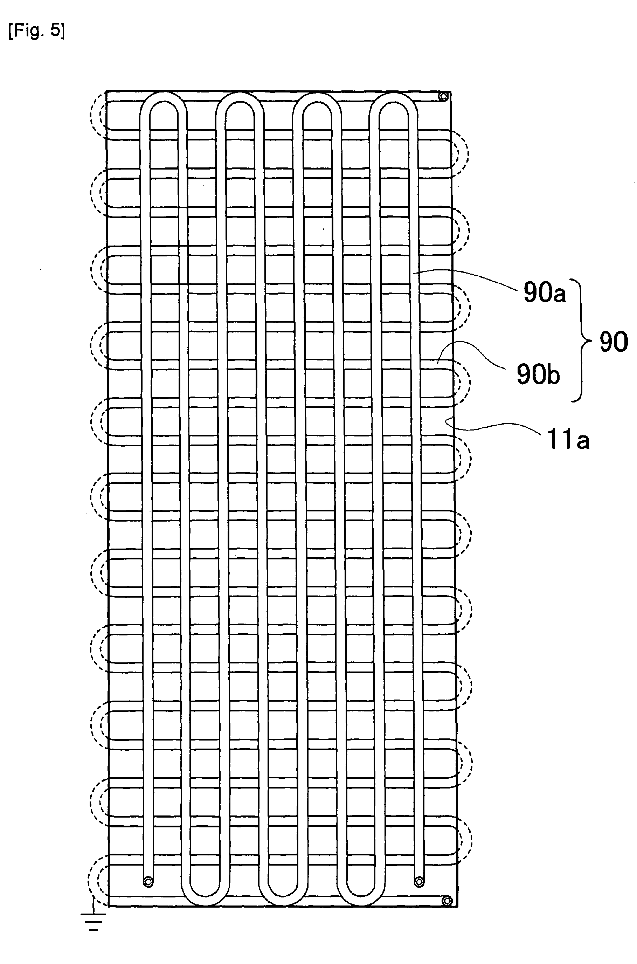

Figs. 1 to 5 illustrate a sputtering apparatus 1. Fig. 1 is a top view of a sputtering apparatus with cross-sections of some parts of interest for facilitating the understanding of readers. Fig. 2 is a lateral view of the thin-film forming apparatus with some parts of interest sectioned along lines A-B and B-C. Fig. 3 shows some parts of interest for illustrating a plasma generating means and an ion quenching means of the invention. Fig. 4 is a sectional view of the plasma generating means cut along line D-D of Fig. 3. The sputtering apparatus 1 is one example of the thin-film forming apparatus according to this invention. Fig. 5 shows some parts of interest for illustrating an ion quenching means.

Here, as an embodiment, employed is a sputtering apparatus 1 based on magnetron sputtering or one example of numerous sputtering apparatuses. However, this invention is not limited to this embodiment, but can be applied to many other publicly known sputtering apparatuses including a dipole sputter not based on magnetron discharge.

According to the sputtering apparatus 1 representing an embodiment of the invention, it is possible to form a thin-film having a desired thickness on a base plate, by forming, by sputtering, a superficial layer having a thickness considerably less in size than the desired thickness on the base plate, applying plasma processing to the superficial layer, and repeating the operation until a thin-film having the desired thickness is obtained. In this embodiment, a cycle of sputtering and plasma processing provides the formation of a superficial layer having a thickness of 0.01 to 1.5 nm on average, and this cycle of processing is repeated until a thin-film having a thickness of several nm to several hundreds nm is obtained.

The sputtering apparatus 1 representing the embodiment comprises a vacuum chamber 11, a base plate holder 13 for holding a base plate upon which a thin-film is to be formed in the vacuum chamber 11, a motor 17 for putting the base plate holder 13 into rotation, magnetron sputtering electrodes 21a, 21b, and a plasma generating means 80 for generating a plasma. In this particular embodiment, a base plate in the form of plates is employed as a substrate. However, a lens or others may be used as a substrate.

The vacuum chamber 11 is made of stainless steel as is commonly observed in a publicly known sputtering apparatus, and is grounded. The vacuum chamber 11 is a hollow body having an approximately rectangular profile. The vacuum chamber 11 may take the form of a cylindrical hollow body.

The base plate holder 13 is disposed approximately at the center of the vacuum chamber 11. The base plate holder 13 takes the form of a cylinder. It holds a plurality of base plates (not shown) on its external wall. The base plate holder 13 corresponds to a substrate holding means of the invention. Although in this particular embodiment the substrate holding means is in the form of a cylinder, the substrate holding means may take the form of a cylinder having a polygonal profile or a cone. The base plate holder 13 is supported rotatably from downward by a rotation axis 17a with a shaft jointed to the vacuum chamber 13 and from upward by a rotation axis 17b with the shaft jointed to the vacuum chamber 13. A rotational driving force from the motor 17 is transmitted via the rotation axis 17a to the base plate holder 13, and the base plate holder 13 is put into rotation round the central axis Z with the vacuum state of the vacuum chamber 11 being maintained. The base plate holder 13 is disposed in the vacuum chamber 11 such that the central longitudinal axis Z (see Fig. 2) of the cylindrical base plate holder 13 corresponds to a longitudinal axis of the vacuum chamber 11.

Joints between the rotation axis 17a and the base plate holder 13, and the rotation axis 17b and the base plate holder 13 are shielded by insulating members 18a, 18b made of an insulating material such as a fluoride resin (Teflon^{™}). By virtue of the insulating members, the base plate holder 13 is electrically isolated from the vacuum chamber 11, and is in a potentially floating state. Putting the base plate holder 13 in a floating state enables the prevention of aberrant discharges which would otherwise occur on a base plate. The arrangement also prevents electrons and ions having a high energy (about 30 eV or more) from impinging upon a base plate, and exerting damaging effects on a film forming on the base plate, and inhibits the undue heating of the base plate holder 13.

An array of numerous base plates (not shown) are arranged on the external surface of the base plate holder 13 longitudinally in parallel with the central axis Z of the base plate holder 13 with a specified interval between adjacent base plates disposed lengthwise. In this particular embodiment, each base plate is held by the base plate holder 13 such that a surface of the base plate upon which a thin-film will be formed ("film forming surface" hereinafter) faces in a direction normal to the central axis Z of the base plate holder 13.

Partition walls 12, 16 are upright members standing from lateral walls of the vacuum chamber 11 towards the base plate holder 13, and fixed by welding or bolting to the radicals, etc. vacuum chamber 11. The partition walls 12, 16 of this embodiment are made of the same stainless steel material as the one used for the construction of the vacuum chamber 11. The partition walls 12, 16 standing upright from the lateral walls of the vacuum chamber 11 towards the base plate holder 13 are so constructed as to surround a space enclosed between the above two members.

There is formed a processing zone 20 for film formation in a space enclosed by the inner wall of vacuum chamber 11, partition wall 12, and the outer surface of the base plate holder 13. There is formed a reactive processing zone 60 in a space enclosed by the inner wall of the vacuum chamber 11, a plasma generating means 80 described later, partition wall 16, and the outer wall of base plate holder 13. The reactive processing zone 60 is an area where plasma processing is applied to a thin-film formed on a base plate using plasma generated by the plasma generating means.

According to this embodiment, the partition wall 16 is attached to at a position about 90° apart, around the central axis Z of the base plate holder 13, from the position at which the partition wall 12 is attached to the vacuum chamber 11. Accordingly, processing zone 20 for film formation and reactive processing zone 60 are separated from each other by about 90° around the central axis Z of the base plate holder 13. Thus, when the base plate holder 13 is put into rotation by the motor 17, each base plate attached to the outer surface of the base plate holder 13 is carried from a position facing the processing zone 20 for film formation to a position facing the reactive processing zone 60, and then to the first-mentioned position to repeat the same cycle. To a space of the vacuum chamber 11 between the processing zone 20 for film formation and the reactive processing zone 60, connected is an exhaust pipe 15a which is in turn connected to a vacuum pump 15 for evacuating the interior of vacuum chamber 11.

The walls of partition wall 16 facing the reactive processing zone 60 are coated with a protective layer P made of an insulating material. Similarly, the inner wall of vacuum chamber 11 facing the reactive processing zone 60 is coated with a protective layer P made of an insulating material. Suitable insulating materials to constitute the protective layer P may include, for example, pyrolytic boron nitride (PBN), aluminum oxide (Al₂O₃), silicon oxide (SiO₂), boron nitride (BN), etc. The protective layer P may be formed by chemical vapor deposition, vapor deposition, or flame coating on the inner wall of the partition wall 16 or the vacuum chamber 11. When PBN is used, PBN is preferably applied, after being heat-decomposed during chemical vapor deposition, to the inner wall of the partition wall 16 or the vacuum chamber 11.

To the processing zone 20 for film formation, mass flow controllers 25, 26 are connected via their respective pipes. The mass flow controller 25 is connected to a sputter gas cylinder 27 which stores inert gas. The mass flow controller 26 is connected to a reactive gas cylinder 28 which stores reactive gas. An inert gas and a reactive gas are introduced into the processing zone 20 for film formation, their flows being controlled by the mass flow controllers 25, 26, respectively. Suitable inert gases to be introduced into the processing zone 20 for film formation may include, for example, argon gas, helium gas, neon gas, krypton gas, xenon gas, etc. Suitable reactive gases to be introduced into the processing zone 20 for film formation may include, for example, oxygen gas, nitrogen gas, fluorine gas, ozone gas, etc.

In the processing zone 20 for film formation, magnetron sputter electrodes 21a, 21b are attached to the wall of vacuum chamber 11 such that the electrodes can face the outer surface of the base plate holder 13. The magnetron sputter electrodes 21a, 21b are fixed via an insulating material not shown to the vacuum chamber 11 which takes a ground potential. The magnetron sputter electrodes 21a, 21b are connected via a transformer 24 to a power supply 23 for giving an alternate voltage of a middle frequency. Thus, the electrodes can apply an alternate electric field. The alternate electric source 23 of the present embodiment can apply an alternate electric field of a frequency in the range of 1 kHz to 100 kHz. The magnetron sputter electrodes 21a, 21b hold their respective targets 29a, 29b. The targets 29a, 29b are in the form of a plate, and the targets 29a, 29b are disposed to face the outer surface of base plate holder 13 such that the surface of the plate is directed normal to the central axis Z of the base plate holder 13.

The wall of vacuum chamber 11 in contact with the reactive processing zone 60 has an opening 11a for receiving a plasma generating means 80. To the reactive processing zone 60, are connected pipes for delivering an inert gas charged in an inert gas cylinder 77 via a mass flow controller 75 to the zone. Similarly connected to the reactive processing zone 60, are pipes for delivering a reactive gas charged in a reactive gas cylinder 78 via a mass flow controller 76 to the zone. Suitable inert gases to be introduced into the reactive processing zone 60 may include, for example, argon gas, helium gas, neon gas, krypton gas, xenon gas, etc. Suitable reactive gases to be introduced into the reactive processing zone 60 may include, for example, oxygen gas, nitrogen gas, fluorine gas, ozone gas, etc.

The plasma generating means 80 will be described with reference to Figs. 1 to 4.
The plasma generating means 80 fits to the opening 11a to be faced with the reactive processing zone 60. The plasma generating means 80 of the present embodiment comprises a case body 81 acting as a lid, dielectric plate 83 acting as a dielectric wall, support frame 84, antennas 85a, 85b, fastener 88, pipe 15a acting as an evacuating means, and vacuum pump 15.

The case body 81 has a shape corresponding to the opening 11a formed on the wall of vacuum chamber 11, and is fixed by bolting (not shown) to the wall of vacuum chamber 11 to close the opening 11a. When the case body 81 is fixed to the wall of vacuum chamber 11, the plasma generating means 80 is properly attached to the vacuum chamber 11. In the present embodiment, the case body 81 is made of stainless steel. The dielectric plate 83 is made of a dielectric material. In the present embodiment, the dielectric plate 83 is made of quartz. The dielectric plate 83 may be made of a ceramics material such as Al₂O₃, instead of quartz.

The support frame 84 is for fixing the dielectric plate 83 to the case body 81, and is in the form of an open square. When the case body 81 is fixed by bolting (not shown) to the support frame 84, the dielectric plate 83 is sandwiched between the support frame 84 and the case body 81, and thus the dielectric plate 83 is fixed to the case body 81. When the dielectric plate 83 is fixed to the case body 81, the dielectric plate 83 together with the case body 81 forms an antenna housing chamber 80A. Namely, according to the invention, there is formed the antenna housing chamber 80A surrounded by the case body 81 and the dielectric plate 83.

The dielectric plate 83 fixed to the case body 81 and fitting to the opening 11a is in contact with the interior of the vacuum chamber 11 (reactive processing zone 60). Meanwhile, the antenna housing chamber 80A is separated from the interior of vacuum chamber 11. Namely, the antenna housing chamber 80A forms a space independent of the vacuum chamber 11 with the dielectric plate 83 acting as a partition. The antenna housing chamber 80A also forms a space independent of space outside the vacuum chamber 11 with the case body 81 as a partition. According to the present embodiment, antennas 85a, 85b are installed in the antenna housing chamber 80A or a space separated from other surrounding spaces as described above. The joints between antenna housing chamber 80A and the reactive processing zone 60 of the vacuum chamber 11, and between the antenna housing chamber 80A and external space of the vacuum chamber 11 are sealed air-tight with O-shaped rings.

According to the embodiment, to evacuate the antenna housing chamber 80A and maintain its vacuum state, an evacuation pipe 15a is connected to the antenna housing chamber 80A. A distal end of pipe 15a is connected to a vacuum pump 15. In the present embodiment, a branch of pipe 15a is connected to the vacuum chamber 11. The one pipe limb coming from the vacuum pump 15 towards the vacuum chamber 11 has valves V1, V2 midway. The other pipe limb coming from the vacuum pump 15 towards the antenna housing chamber 80A has valves V1, V3 midway. When either V2 or V3 is closed, air flow through the pipe limb leading to the vacuum chamber 11 or to the antenna housing chamber 80A is intercepted, depending on the valve closed. The pressures within the vacuum chamber 11 and the antenna housing chamber 80A are monitored with respective vacuum indicators (not shown).

According to the present invention, the sputtering apparatus 1 is equipped with a controller (not shown). Outputs from the vacuum indicators are fed to the controller. The controller has a function to control the evacuation of the vacuum chamber 11 and the antenna housing chamber 80A by adjusting evacuation exerted by the vacuum pump 15 based on measurements fed as input from the vacuum indicators. In this embodiment, the controller can evacuate the vacuum chamber 11 and the antenna housing chamber 80A simultaneously or independently of each other by selectively operating the open/closure of valves V1, V2, V3 as needed.

The antennas 85a, 85b are for evoking an inductive field in vacuum chamber 11 (reactive processing zone 60) in response to electric power supplied by an RF power source 89, thereby generating a plasma there. The antenna 85a, 85b of the embodiment comprises a copper-made cylindrical body and a silver-made coating layer coating the cylindrical body. The antenna 85a, 85b is preferably made of a material having a low electric resistance, so that the antenna 85a can have a low impedance. In view of this, the observation that a high frequency current tends to flow at the periphery of conductor is made the most of as follows. A conductor body in the form of a cylinder is made of copper which is cheap, easy for processing, and conductive, while a surface coat is made of silver which is more conductive than copper, and the resulting silver-coated copper conductor is used as a material of the antennas 85a, 85b. The antenna 85a, 85b made of such a conductor has a lowered impedance, and thus this configuration allows the antenna 85a more effective passage of electric current, thereby increasing the efficiency of plasma generation.

Each of the antenna 85a and the antenna 85b takes the form of a flat spiral. The antennas 85a and 85b in the form of a flat spiral are installed in the antenna housing chamber 80A formed between the case body 81 and the dielectric plate 83 such that each spiral directs its planar face towards the reactive processing zone 60, and is adjacent to the dielectric plate 83. In other words, the antennas 85a and 85b in the form of a planar spiral are placed with respect to the dielectric plate 83 in such a manner as to allow the planar surfaces of spirals to face the dielectric plate 83, and the antenna 85a and the antenna 85b are placed adjacent to each other so that a line connecting the central axes of the two spirals runs vertically (in parallel with the central axis Z).

Namely, antenna 65a and antenna 65b in the form of a planar spiral (facing dielectric plate 63) are arranged to each other such that a line connecting the central axes of planar spiral surfaces runs vertically, and the two planar spirals are apart from each other by a specified distance D as shown in Figs. 2 and 4. Accordingly, when motor 17 is activated to rotate base plate holder 13 round the central axis Z, a longitudinal row of base plates attached to the outer surface of base plate holder face the planar spiral surfaces of the vertically arranged antennas 85a, 85b, and with the rotation of base plate holder 13, longitudinal rows of base plates move crosswise one after another.

The antennas 85a and 85b are connected in parallel to the RF power source 89. The antennas 85a and 85b are connected to the RF power source 89 via a matching box 87 containing a matching circuit. The matching box 87 contains variable capacitors 87a, 87b as shown in Fig. 4. Since, in this embodiment, the antenna 85b is connected to the power source in parallel with the antenna 85a, the antenna 85b can bear part of the duty assigned to antenna 85a which has been performed exclusively by the antenna 85a in a conventional apparatus. This contributes to the reduced loss of power in the matching box which enables the improved utilization of electric power to be supplied to the antennas 85a, 85b which in turn contributes to the effective generation of plasma. This arrangement also facilitates impedance matching.

The spiral-shaped antennas 85a, 85b are connected via wire portions 86a, 86b to the matching box 87. The wire portions 86a, 86b are made of the same material as the one used for the construction of the antennas 85a, 85b. The case body 81 have through-holes 81a for permitting the penetration of the wire portions 86a, 86b. The antennas 85a, 85b installed in the antenna housing chamber 80A are connected via the wire portions 86a penetrating through-holes 81a to the matching box 87 and the RF power source 89 outside the antenna housing chamber 80A. Between the wire portions 86a, 86b and the through-holes 81a there are provided a sealing members 81b so that the antenna housing chamber 80A can be kept air-tight.

In this embodiment, the wire portions 86a and 86b are made so redundant in length as to permit adjustment of the interval D between the antenna 85a and the antenna 85b. The sputtering apparatus 1 representing the embodiment allows a user to adjust the vertical interval D between the antenna 85a and the antenna 85b before the antennas 85a, 85b are fixed by the fasteners 88.

The fasteners 88 are provided to secure the antennas 85a, 85b in the antenna housing chamber 80A. The fasteners 88 of the present embodiment comprise fastening plates 88a, 88b and fastening bolts 88c, 88d. The fastening plates 88a, 88b fit to the antennas 85a, 85b, respectively. The fastening plates 88a, 88b engaging with the antennas 85a, 85b are fixed to the case body 81 by means of the fastening bolts 88c, 88d. The case body 81 has a plurality of vertically arranged holes, and the fastening plates 88a, 88b are jointed to the case body 81 via bolts passing through appropriately chosen holes. Namely, the vertical interval D between the antennas 85a, 85b can be adjusted by choosing holes through which bolts will be passed as appropriate. To insulate the antennas 85a, 85b from the fastening plates 88a, 88b, the interfaces between the antennas 85a, 85b and the fastening plates 88a, 88b are made of an insulating material.

Procedures taken for mounting the plasma generating means 80 configured as described above to the vacuum chamber 11 will be described below.
First, the antennas 85a, 85b are fixed to the case body 81 by means of the fasteners 88. Prior to this operation, the fasteners 88 having an appropriate size in accordance with the vertical interval D between the antennas 85a and 85b, and the radius Ra of the antenna 85a and radius Rb of the antenna 85b should be chosen. Then, the dielectric plate 83 is fixed to the case body 81 by means of the support frame 84. Through this operation, the antennas 85a, 85b are held between the dielectric plate 83 and the fastening plates 88a, 88b. Thus, the case body 81, the dielectric plate 83, the antennas 85a, 85b and the fasteners 88 are integrated together. Then, the case body 81 is fixed by bolting (not shown) to the vacuum chamber 11 so as to close the opening 11a of the vacuum chamber 11. As a result of the procedures described above, the plasma generating means 80 is mounted to the vacuum chamber 11, and the antenna housing chamber 80A, the reactive processing zone 60 (formed in the interior of the vacuum chamber 11), and outside space are produced to form spaces independent of each other. The antennas 85a, 85b are installed in the antenna housing chamber 80A.

According to this embodiment, the case body 81 is fixed by bolting to the vacuum chamber 11 so that the plasma generating means is jointed to the vacuum chamber 11 while the case body 81 is integrated with the dielectric plate 83, the antennas 85a, 85b, and the fasteners 88. Therefore, attaching or detaching the plasma generating means 80 to or from the vacuum chamber 11 can be done easily.

In this embodiment, a grid 90 as shown in Figs. 1, 3, and 5 is inserted between the plasma generating means 80 and the base plate holder 13. The grid 90 corresponds to an ion quenching means of the present invention, and is introduced for quenching part of ions and electrons generated by the plasma generating means 80.

Fig. 5 is a top view of the grid 90 fitting to the opening 11a viewed from the plasma generating means 80 towards the base plate holder 13.
As shown in Fig. 5, the grid 90 is a hollow member made of conductor, and grounded. To both ends of each hollow member constituting the grid 90, are connected hoses (not shown) for allowing the passage of cooling medium (for example, cooling water) through the conductor of the grid 90.

The grid 90 of the embodiment comprises a vertical grid 90a and a horizontal grid 90b. The vertical grid 90a is made by arranging a hollow member in plural vertical columns in parallel with the central axis Z (longitudinal direction) while the horizontal grid 90b is made by arranging a hollow member in plural horizontal rows in parallel with the rotation direction of the base plate holder 13 (crosswise direction). The grid 90 is made of a conducting material such as copper, copper alloy, aluminum, stainless steel, etc.

In this embodiment, the grid is made of two copper tubes one (vertical grid 90a) arranged in vertical columns and the other (horizontal grid 90b) in horizontal rows as shown in Fig. 5. The vertical grid 90a and the horizontal grid 90b are fixed to the vacuum chamber 11. In the embodiment, the horizontal grid 90b is fixed to the vacuum chamber 11 by means of a fastening plate 91 which is jointed by bolting to the vacuum chamber 11. The vertical grid 90a is bonded to the horizontal grid 90b by welding or by an adhesive. The vertical grid 90a may be fixed by a fastening plate 91.

As shown in Fig. 5, when the plasma generating means 80 are projected as it is to the substrate holder 13, two parallel images one representing the peripheral margins of the opening 11a and the other representing grid 90 are formed on the substrate holder 13. The vertical grid 90a and the horizontal grid 90b are so constructed as to make the projected image of the grid 90 smaller than the projected image of the peripheral margins of the opening 11a. To put it otherwise, when the plasma generating means 80 framed by opening 11a is projected directly onto the substrate holder 13, its central image is shielded by the grid 90 standing midway to produce a shade on the base plate holder 13 while its peripheral image or the peripheral margins of the opening 11a not being shielded by the grid 90 produces a projected image upon the substrate holder 13. The vertical grid 90a and the horizontal grid 90b are so constructed as to make the central shade smaller in area than the image of peripheral margins of the opening 11a.

Next, procedures undertaken for generating a plasma in reactive processing zone 60 in the sputtering apparatus 1 of the embodiment will be described.
First, the vacuum chamber 11 and the antenna housing chamber 80A are evacuated by activating the vacuum pump 15. During this operation, the controller opens all the valves V1, V2 and V3 provided to the pipes 15a in order to aspirate air from the vacuum chamber 11 and the antenna housing chamber 80A simultaneously to produce vacuum in the vacuum chamber 11 and the antenna housing chamber 80A. The controller checks the readings provided by vacuum indicators, and adjusts as appropriate the open/closure of the valves V1, V2, V3 to restrict the pressure difference between the vacuum chamber 11 and the antenna housing chamber 80A to be within a specified range (for example, not to make the pressure difference more than 10⁴ Pa). Later, when the controller finds that the pressure of the vacuum chamber 11 is in the range of 10⁻² to 10 Pa, it temporarily closes the valve V2. The pressure of the antenna housing chamber 80A is then reduced to a level equal to or less than 10⁻³ Pa. At this point, the controller closes Valve V3. Then, while the pressure of vacuum chamber 11 is maintained at 10⁻² to 10 Pa, a reactive gas charged in the reactive gas cylinder 78 is introduced via the mass flow controller 76 to the reactive processing zone 60.

While the pressures of the vacuum chamber 11 and the antenna housing chamber 80A are maintained at respective specified levels, voltage having a frequency of 13.56 MHz is applied to the antennas 85a, 85b from the RF power source 89 to generate a plasma in the reactive processing zone 60. At this moment, a plasma is generated whose expanse varies depending on the vertical interval D between the antennas 85a and 85b, and the radius Ra and Rb of the antennas 85a, 85b.

Then, plasma processing is applied to a thin-film forming on a abase plate arranged on the base plate holder 13 by means of active species such as ions, electrons, and radicals contained in plasma derived from reactive gas. In this embodiment, out of ions, electrons and radicals contained in plasma, part of ions and part of electrons are neutralized by the grid 90 inserted between the plasma generating means 80 and the base plate holder 13. In this embodiment, since the projection image of the plasma generating means 80 shielded by the grid 90 has an area smaller than the residual image of the plasma generating means 80 or the opening 11a projected onto the substrate holder 13, it is possible to restrict the amount of ions generated by the plasma generating means 80 which will be quenched by the grid 90.

If, on the contrary, the projection image of the plasma generating means 80 shielded by the grid 90 has an unduly large area, the majority of ions generated by the plasma generating means 80 will be neutralized by the grid 90, and the amount of ions brought into contact with a thin-film forming on a base plate will be limited. In contrast, if, as in the present embodiment, the projection image of the plasma generating means 80 shielded by the grid 90 has a limited area, as compared with the residual image of the opening 11a projected onto the base plate holder 13, it is possible to restrict the amount of ions to be quenched by the grid 90, and thus to prevent the amount of ions in contact with a thin-film from falling to an extremely low level.

As described above, according to this embodiment, it is possible to maintain the pressure of vacuum chamber 11 where a thin-film is formed and plasma processing applied to the film, at a level suitable for the development of plasma, and also to maintain the pressure of the antenna housing chamber 80A or another evacuated space independent of the vacuum chamber 11, at a level sufficiently low to inhibit the development of plasma. Thus, it is possible to efficiently develop a plasma in the vacuum chamber 11 while inhibiting the development of plasma within the antenna housing chamber 80A.

Further, according to this embodiment, the antenna housing chamber 80A and the vacuum chamber 11 are spaces independent of each other with the dielectric plate 83 as a partition; the antennas 85a, 85b are installed in the antenna housing chamber 80A; and a plasma is generated in the vacuum chamber 11 while the antenna housing chamber 80A is evacuated. This arrangement is in contrast with a conventional apparatus where the antennas 85a, 85b are exposed to the atmosphere. According to the embodiment, it is possible to prevent the antennas 85a, 85b from being oxidized. Accordingly, the antennas 85a, 85b will have a prolonged life, and it is also possible to prevent plasma from becoming unstable which would result from the oxidization of the antennas 85a, 85b.

According to the embodiment, the apparatus checks the pressures of the vacuum chamber 11 and the antenna housing chamber 80A, controls the pressures of the vacuum chamber 11 and the antenna housing chamber 80A so that the pressure difference between the two chambers does not exceed a specified value, maintains the pressure of vacuum chamber 11 at 10⁻² to 10 Pa, and the pressure of the antenna housing chamber 80A at 10⁻³ Pa or less, so that a plasma is generated in the vacuum chamber 11. The antenna housing chamber 80A is separated from the vacuum chamber 11 by means of the dielectric plate 83 and the antenna housing chamber 80A and the vacuum chamber 11 are separated from outside space by means of the case body 81. Thus, as compared with a conventional apparatus where the antennas 185 are exposed to the atmosphere and the vacuum chamber 11 is separated from outside space by means of the dielectric plate 183, it is possible to safely operate with the dielectric plate 83 having a smaller thickness, since with the present embodiment it is possible to maintain the pressure difference between the antenna housing chamber 80A and the vacuum chamber 11 at a smaller value, which allows the more efficient development of plasma, use of a cheaper dielectric plate 83, and more low cost operation of the apparatus.

According to the embodiment, it is also possible to adjust the expanse of plasma applied to a base plate arranged on a base plate holder 13 by varying the vertical interval D between the antenna 85a and the antenna 85b. In addition, since it is possible according to the embodiment to adjust the radius Ra of the antenna 85a, radius Rb of the antenna 85b, and thickness of conductors constituting the antennas 85a, 85b independently of each other, it is also possible to adjust the expanse of plasma by varying the radius Ra of the antenna 85a, radius Rb of the antenna 85b, and thickness of conductors constituting the antennas 85a, 85b. In this particular embodiment, each of antennas 85a, 85b has an overall shape consisting of concentric semi-circles as shown in Fig. 4. However, even when the antennas 85a, 85b are in the form of a square, it is possible for them to adjust the expanse of plasma.

According to the embodiment, columns of base plates are moved horizontally one after another, and the antennas 85a and 85b are arranged vertically with the interval between the two antennas being variable. Thus, when it is required to widely change the expanse of plasma in a direction normal to the direction in which columns of base plates are carried, the requirement can be readily met. For example, when plasma processing is carried out by a carousel-type sputtering apparatus 1 like the present embodiment, it occasionally happens that a thin-film formed at an upward position of a base plate holder 13 has a thickness different from that of a thin-film formed at a middle position, depending on the given sputtering condition including the arrangement of base plates on the base plate holder 13. Such inadvertent detrimental operation, however, could be readily met if the apparatus incorporates a plasma generating means 80 of the present embodiment, because then it is readily possible to adjust the density distribution of plasma so as to minimize the difference in thickness of thin-films.

As described above, according to the embodiment, the surface of the partition wall 16 facing the reactive processing zone 60, and inner surface of the vacuum chamber 11 facing the reactive processing zone 60 are coated with an insulating material. This makes it possible to maintain the relative density of radicals in the reactive processing zone 60 at a high level, thereby allowing a large number of radicals to contact with a thin-film on a base plate, which improves the efficiency of plasma processing. Specifically, in the embodiment, PBN as a chemically stable compound is applied to the inner surfaces of the partition wall 16 and the vacuum chamber 11 to form a coat there, and the coat prevents radicals including excited ones produced in the reactive processing zone 60 by the plasma generating means 80 from being annihilated after they collide to the inner surfaces of the partition wall 16 and the vacuum chamber 11. The partition wall 16 can direct radicals generated in the reactive processing zone 60 towards the base plate holder.

Furthermore, according to this embodiment, since the projection image of the opening 11a masked by the grid 90 has an area smaller than the residual image of the opening 11a projected onto the base plate holder 13, it is possible to restrict the amount of ions derived from reactive gas which will be electrically neutralized by the grid 90, and to adjust the amount of ions in contact with a thin-film.

As an example of plasma processing carried out by the sputtering apparatus 1 as described above, a case will be described where a thin-film made of incompletely oxidized titanium oxide (TiOₓ₁ (x1 < 2)) has been formed by sputtering on a base plate, and plasma processing is applied to the thin-film to produce a thin-film made of more completely oxidized titanium oxide (TiOₓ₂ (x1 < x2 ≦ 2)). An incompletely oxidized titanium oxide refers here to a titanium oxide in which the constitutive element oxygen is in shortage, that is, TiOₓ (x < 2).

First, a base plate, and targets 29a, 29b are mounted to a sputtering apparatus 1. The base plate is attached to a base plate holder 13. The targets 29a, 29b are attached to their respective magnetron sputter electrodes 21a, 21b. The targets 29a, 29b are made of titanium (Ti).
Then, the vacuum chamber 11 and the antenna housing chamber 80A are evacuated to their respective desired pressure levels, and the motor 17 is activated to rotate the base plate holder 13. After the vacuum chamber 11 and the antenna housing chamber 80A maintain their respective desired pressure levels stably, the apparatus adjusts the pressure of processing zone 20 for film formation at 0.1 to 1.3 Pa.

Next, argon gas as an inert gas for sputtering and oxygen gas as a reactive gas are delivered from the sputter gas cylinder 27 and the reactive gas cylinder 28 respectively into the processing zone 20 for film formation with their flows being controlled by means of the mass flow controllers 25, 26. The delivery of gases is adjusted to provide the processing zone 20 for film formation with an atmosphere suitable for sputtering.

Next, middle frequency power source 23 is activated to provide electricity via a transformer 24 to magnetron sputter electrodes 21a, 21b. Thus, an alternate voltage of 1 to 100 KHz is applied across the two electrodes. The voltage is also imposed upon the targets 29a, 29b. Then, at a certain time point, the target 29a becomes a cathode (minus electrode) while the target 29b necessarily becomes an anode (plus electrode). At another time point, the target 29b now becomes a cathode (minus electrode) while the target 29a now takes an anode (plus electrode). As described above, the pair of the targets 29a, 29b become anode and cathode alternately, which evokes the formation of plasma, and causes the target on the cathode to be sputtered.

During sputtering, titanium oxide (TiOₓ (x ≦ 2)) which is nonconductive or lower conductive may attach on the surface of a anode. However, when the anode becomes a cathode as a result of alternately changing voltage, the impurities of titanium oxide (TiOₓ (x ≦ 2)) will be sputtered away from the surface of cathode, and the surface of the target will become an original clear state. Moreover, since the pair of the targets 29a, 29b become anode and cathode alternately, the electric potential of the anode becomes stabilized, and variation of plasma potential (usually being equal to anode potential) is minimized. Thus, a thin-film made of titanium or incompletely oxidized titanium oxide (TiOₓ₁ (x1 < 2)) is stably formed on the surface of a base plate.

It is possible to vary the composition of a film formed in the processing zone 20 for film formation by adjusting the inflow of oxygen gas to the zone or controlling the rotation speed of the base plate holder 13. For example, it is possible by so doing to make a film composed of titanium (Ti), titanium oxide (TiO₂) or incomplete titanium oxide (TiOₓ₁ (x1 < 2)).

After a film composed of titanium or incomplete titanium oxide (TiOₓ₁ (x1 < 2)) has been formed in the processing zone 20 for film formation, the base plate holder 13 is allowed to rotate, so that the base plate staying at a position facing the processing zone 20 for film formation moves to a position facing the reactive processing zone 60. Oxygen gas as a reactive gas is introduced from the reactive gas cylinder 78 into the reactive processing zone 60. At the same time, an inert gas (for example, argon gas) is introduced into the same zone from the inert gas cylinder 77. As seen from above, into the reactive processing zone 60, not only reactive gas such as oxygen but also inert gas are introduced. This contributes to the increased density in plasma of radicals derived from reactive gas.

Next, an RF voltage having a frequency of 13.56 MHz is applied to the antennas 85a, 85b, to cause the plasma generating means 80 to generate plasma in reactive processing zone 60. The pressure of the reactive processing zone 60 is maintained at 0.7 to 1 Pa. As long as plasma is generated in the reactive processing zone 60, the pressure of antenna housing chamber 80A is kept at 10⁻³ Pa or less.

Then, the base plate holder 13 is allowed to rotate so that a base plate carrying on its surface a film composed of titanium or incomplete titanium oxide (TiOₓ₁ (x1 < 2)) moves to a position facing the reactive processing zone 60. In the reactive processing zone 60, plasma processing is applied to a film composed of titanium or incomplete titanium oxide (TiOₓ₁ (x1 < 2)) to oxidize it. Specifically, plasma generating means 80 generates plasma from oxygen gas in the reactive processing zone 60, and causes plasma to oxidize the titanium or incomplete titanium oxide (TiOₓ₁ (x1 < 2)) constituting the film to convert it into less incomplete titanium oxide (TiOₓ₂ (x1 < x2 < 2)) or complete titanium oxide (TiO₂) as desired.

According to the embodiment, it is possible by employing procedures as described above to form a thin-film composed of (TiOₓ (x ≦ 2)) as desired. Furthermore, by repeating the above procedures, it is possible to overlap thin-layers one over another to form a thin-film having a desired thickness.

Plasma derived from reactive gas is likely to exert two effects in the reactive processing zone 60. A first effect is the promotion of oxidization reactions over a thin-film. Through this effect it is possible for a metal or incomplete metal oxide constituting a thin-film as a result of previous sputtering to be converted into a less incomplete metal oxide or complete metal oxide. A second effect is the deoxydization of a thin-film which occurs as a result of the collision of high energy ions or electrons of plasma from reactive gas against the thin-film which exert adverse effects on the thin-film. The composition of a thin-film having undergone plasma processing performed in the reactive processing zone 60 is likely to be determined by the net result of the two competitive effects.

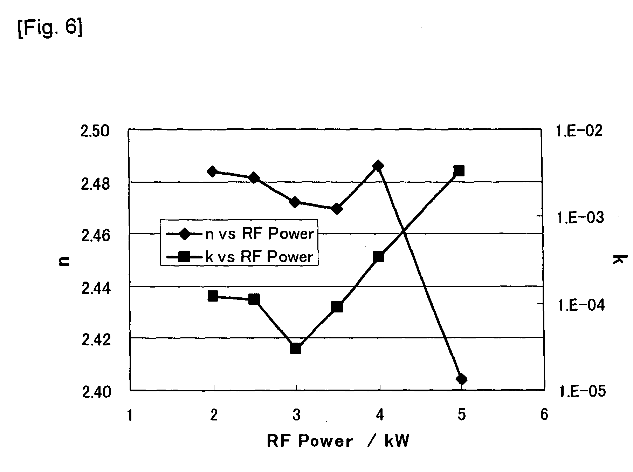

Fig. 6 shows graphs relating electric power supplied to the antennas 85a, 85b to two optical constants (refractive index n and attenuation factor k) of a TiO₂ thin-film. The abscissa of the graph shown in Fig. 6 refers to electric power supplied to the antennas 85a, 85b. One ordinate (left one) of the graph of Fig. 6 indicates the refractive index n of a thin-film and the other ordinate (right one) the attenuation factor k of the thin-film.

As seen from the graphs of Fig. 6, when power over 4 kW is supplied, the attenuation factor k increases rapidly (for example, when power of 5 kW is supplied, the attenuation factor k goes beyond 1.0 x 10⁻³). In contrast, when power whose magnitude is in the range of 2 to 4 kW is supplied, it is possible to obtain a thin-film having a refractive index n of 2.47 to 2.49 and attenuation factor k of 1.0 x 10⁻³ or less.

When power whose magnitude is over 4 kW is supplied to the antennas 85a, 85b, a film will have an unduly large attenuation factor k. This is probably because the antennas 85a, 85b being supplied high electric power cause the ample generation of high energy ions and electrons from reactive gas, which emphasizes the above-mentioned second effect.

Thus, as a means to restrict the generation of excess amounts of high energy ions and electrons from reactive gas and to reduce the attenuation factor k of a developing thin-film, it is recommended to maintain power supplied by the RF power source 89 to the antennas 85a, 85b within the range of not less than 2 kW but not more than 4 kW. Further, if it is desired to maintain the attenuation factor k of a thin-film at about 1.0 x 10⁻⁴, it is recommended to keep power supplied by the RF power source 89 to the antennas 85a, 85b within the range of not less than 2 kW but not more than 3.5 kW.

One embodiment of the invention has been described above. The embodiment may be modified to produce, for example, following variants (a) to (1). The variants (a) to (1) may be combined as appropriate to give further variations. In the following description, a member corresponding to a member of the above embodiment will be represented by the same symbol.

(a) In the above embodiment, the grid 90 is a hollow member made of conductor. However, the grid may be constituted of a rod-shaped memeber made of an insulating material. In this case, as in the above embodiment, the grid 90 is preferably constituted of the vertical grid component 90a and the horizontal grid component 90b. The vertical grid component 90a is made by arranging a rod-shaped member in plural vertical columns in parallel with the central axis Z (longitudinal direction) while the horizontal grid component 90b is made by arranging a rod-shaped member in plural horizontal rows in parallel with the rotation direction of base plate holder 13 (crosswise direction).

In this embodiment as in the above embodiment, when the plasma generating means 80 are projected directly to substrate holder 13, two parallel images one representing the peripheral margins of opening 11a and the other representing grid 90 are formed on the substrate holder 13. The vertical grid 90a and the horizontal grid 90b are so constructed as to make the projected image of the grid 90 smaller than the projected image of the peripheral margins of the opening 11a. To put it otherwise, when the plasma generating means 80 framed by the opening 11a is projected directly onto the substrate holder 13, its central image is shielded by the grid 90 standing midway to produce a shade on the base plate holder 13 while its peripheral image or the peripheral margins of the opening 11a not being shielded by the grid 90 produces a projected image upon the substrate holder 13. The vertical grid 90a and the horizontal grid 90b are so constructed as to make the central shade smaller in area than the image of peripheral margins of the opening 11a.

Installment of a grid 90 made of a solid insulating body configured as described above, makes it possible to capture part of ions contained in plasma generated by the plasma generating means 80 to quench them. Like the above embodiment, according to this embodiment, the grid-shielded area of the projected image of the opening 11a is made smaller than the marginal areas of the same projected image. Through this arrangement, it is possible to restrict the amount of ions derived from reactive gas that will be electrically neutralized by the grid 90, and to prevent the amount of ions in contact with a thin-film from decreasing to an unduly low level.

Suitable insulating materials to constitute the grid 90 may include, for example, pyrolytic boron nitride (PBN), aluminum oxide (Al₂O₃), silicon oxide (SiO₂), boron nitride (BN), aluminum nitride (AlN), etc. The rod-shaped member to constitute the grid 90 is not necessarily made of a completely insulating material. The solid rod may be a hollow conductor (for example, stainless steel, copper, copper alloy, or aluminum) coated by an insulating material such as pyrolytic boron nitride (PBN), aluminum oxide (Al₂O₃), silicon oxide (SiO₂), boron nitride (BN), aluminum nitride (AlN), etc., which may be a constituent of the grid 90. Coating of a conductor with an insulating material may be achieved by chemical vapor deposition, vapor deposition, or flame coating, as in the formation of a protective layer P described above.

(b) In the above embodiment, a sputtering apparatus was described as an example of a thin-film forming apparatus. However, the inventive plasma generating means can be applied to other thin-film forming apparatuses. Suitable thin-film forming apparatuses for this purpose may include an etching apparatus using plasma, CVD apparatus for performing CVD, and surface treating apparatus for treating the surface of plastics using plasma.

(c) In the above embodiment, a so-called carousel-type sputtering apparatus is employed. However, the present invention is not limited to this type of sputtering apparatus. The invention can be applied to any sputtering apparatus as long as the apparatus allows base plates to be carried one after another to a zone where plasma is generated.

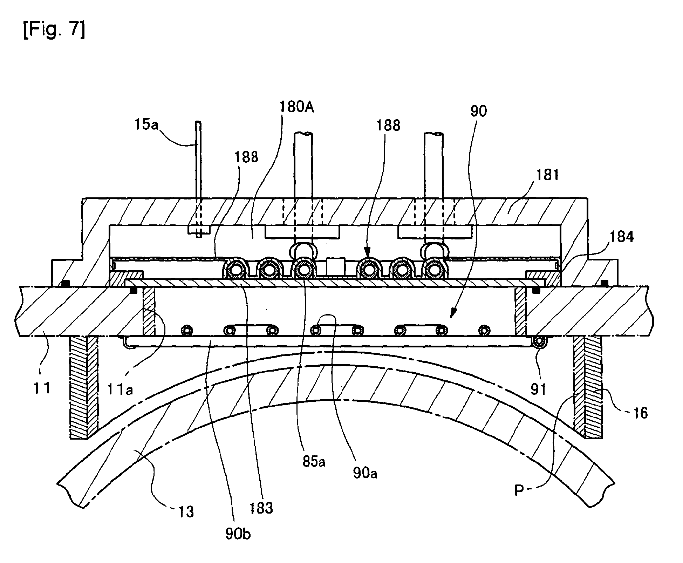

(d) In the above embodiment, the support frame 84 is used to fix the dielectric plate 83 to the case body 81, thereby integrating the case body 81, the dielectric plate 83, the antennas 85a, 85b, the fasteners 88 into a unified unit. Under this condition, the case body 81 is jointed by bolting to the vacuum chamber 11 to connect the plasma generating means to the vacuum chamber 11. However, fixation of the dielectric plate 83 and connection of plasma generating means are not limited to the above methods. For example, variant methods as shown in Fig. 7 may be employed. Fig. 7 shows some parts of interest for illustrating another embodiment of the plasma generating means. According to the embodiment shown in Fig. 7, the support frame 184 is fixed by bolting (not shown) to the vacuum chamber 11 with the dielectric plate 183 inserted between the vacuum chamber 11 and the support frame 184, thereby fixing the dielectric plate 183 to the vacuum chamber 11. In addition, the case body 181 acting as a lid of the inventive apparatus is fixed by bolting to the vacuum chamber 11 as if to cover the dielectric plate 183, thereby connecting the plasma generating means 180 to the vacuum chamber 11.

Then, the antenna housing chamber 180A is formed being enclosed by the case body 181 and the dielectric plate 183. A pipe 15a is connected to the antenna housing chamber 180A to evacuate it. The distal end of pipe 15a is connected to the vacuum pump 15. Incidentally, in the first-mentioned embodiment, the antennas 85a, 85b are fixed by means of the fasteners 88 to the case body 81. In the same manner, the antennas 85a, 85b are fixed by means of the fasteners 188 to the case body 181. When the case body 181 is removed from the vacuum chamber 11, it is readily possible to attach or detach the antennas 85a, 85b to or from the apparatus, or to alter the shape of the antennas 85a, 85b.

(e) In the above embodiment, the plasma generating means comprises an induction-coupling (planar) type plasma generating means including the antennas 85a, 85b each in the form of a planar spiral facing the dielectric plate 83 as shown in Figs. 1 and 4. The invention, however, may be applied to a thin-film forming apparatus incorporating another type of plasma generating means. Specifically, the invention may be applied to an induction coupled type (cylindrical) plasma generating means. This plasma generating means comprises an antenna obtained by winding a wire around the external wall of a dielectric cylinder to produce an antenna in the form of a spiral, which, when supplied RF power, evokes an induction field in a space surrounded by the dielectric cylinder, thereby generating plasma there.

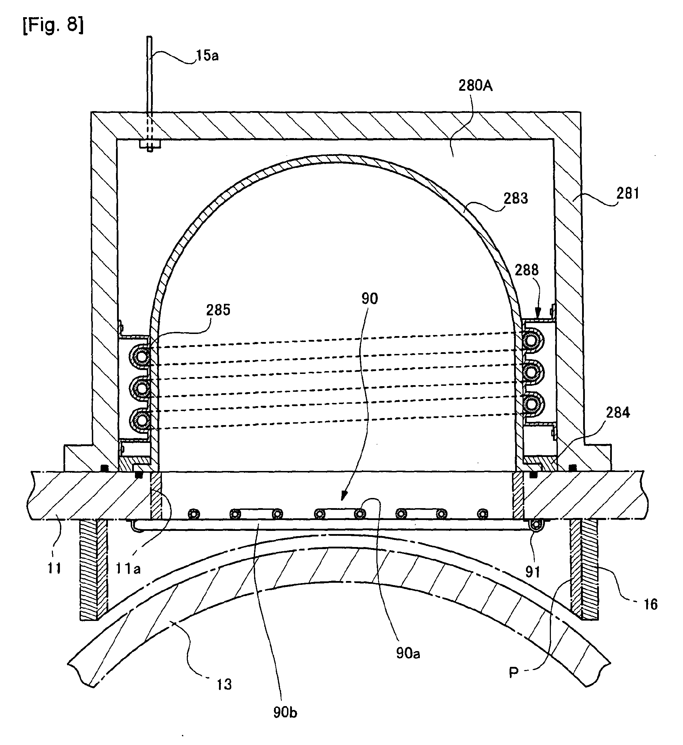

Fig. 8 shows some parts of interest for illustrating an induction coupled type (cylindrical) plasma generating means. According to the embodiment shown in Fig. 8, the inventive dielectric wall comprises a dielectric plate 283. The dielectric plate 283 is bent into a cylinder. A support frame 284 is fixed by bolting (not shown) to the vacuum chamber 11 with a dielectric plate 283 inserted between the vacuum chamber 11 and the support frame 284, thereby fixing the dielectric plate 283 to the vacuum chamber 11. In addition, the case body 281 acting as a lid of the inventive apparatus is fixed by bolting to vacuum chamber 11 as if to cover the dielectric plate 283, thereby connecting the plasma generating means 280 to the vacuum chamber 11.

Then, the antenna housing chamber 280A is formed being enclosed by the case body 281 and dielectric plate 283. A pipe 15a is connected to antenna housing chamber 280A to evacuate it. The distal end of pipe 15a is connected to vacuum pump 15. An antenna 285 comprises a wire wound around the outer wall of a cylindrical dielectric plate. In the same manner as in the first-mentioned embodiment where the antennas 85a, 85b are fixed by means of the fasteners 88 to the case body 81, the antenna 285 is fixed by means of the fastener 288 to the case body 281. When the case body 281 is removed from the vacuum chamber 11, it is readily possible to attach or detach the antenna 285 to or from the apparatus, or to alter the shape of the antenna 285.

In the embodiment shown in Fig. 8, the dielectric plate 283 is sandwiched between the case body 281 and the support frame 84 to thereby fix the dielectric plate 238 to the case body 281, which enables the integration of the case body 281, the dielectric plate 283, the antenna 285, the fasteners 288 into a unified unit. When the apparatus is configured as described above, it is readily possible to connect the plasma generating means 280 to the vacuum chamber 11 by joining the case body 281 by bolting to the vacuum chamber 11. Thus, it becomes readily possible to attach or detach the plasma generating means 280 to or from the vacuum chamber 11.

(f) In the above embodiment, a pipe system 15a is connected to the vacuum chamber 11 and the antenna housing chamber 80A, and the vacuum pump 15 connected to the pipe system 15a is activated to evacuate the vacuum chamber 11 and the antenna housing chamber 80A. However, instead of the pipe system, independent pipes may be separately connected to the vacuum chamber 11 and the antenna housing chamber 80A to evacuate the two chambers independently of each other.

(g) In the above embodiment, the fasteners 88a, 88b are brought into intimate contact with the dielectric plate 83, and their ends are fixed to the case body 81 by means of fixing bolts 88c, 88d, thereby installing the antennas 85a, 85b in the antenna housing chamber 80A. However, the fixing method is not limited to above. As long as the interval D of the two antennas can be varied, any other fixing method may be employed.

(h) In the above embodiment, the walls of the partition wall 16 facing the reactive processing zone 60 and the inner wall of the vacuum chamber 11 facing the reactive processing zone 60 are coated with a protective layer P made of an insulating material. The protective layer P made of an insulating material may be applied to other parts of the apparatus. For example, not only the walls of partition wall 16 facing the reactive processing zone 60 but also other walls of partition wall 16 may be coated with an insulating material. Through this configuration, it is possible to minimize the loss of radicals which would otherwise result from the reaction of ions with a material constituting partition wall 16. In addition, for example, not only the inner wall portion of vacuum chamber 11 facing reactive processing zone 60 but also other inner wall portions of vacuum chamber 11, for example, the entire inner surfaces of the vacuum chamber 11 may be coated with an insulating material. Through this configuration, it is possible to minimize the loss of radicals. Partition wall 12 may also be coated with an insulating material.

(i) In the above embodiment, the antenna 85a is constituted of a copper hollow cylinder as a main body coated with silver. However, the combination of metals is not limited to above. Any other combination of two metals may be employed, as long as the main body is made of a metal cheaper, easier for processing, and acceptably electro-conductive, while the coat is made of a metal more electro-conductive. For example, the hollow core may be made of aluminum or an aluminum-copper alloy, while the coat may be made of copper or gold. This holds true also for the conductor constituting the antenna 85a which consists of a core conductor with a coat. Further, the material of the conductor of the antenna 85 may be different from that of the antenna 85b.

(j) In the above embodiment, oxygen gas is introduced into the reactive processing zone 60 as a reactive gas. However, oxygen gas may be substituted for oxidizing gas such as ozone, dinitrogen monoxide (N₂O), etc., or nitriding gas such as nitrogen, etc., carbonizing gas such as methane, etc., or fluoriding gas such as fluorine, carbon tetrafluoride (CF₄), etc. Thus, the invention may be applied plasma processing not based on oxidization.

(k) In the above embodiment, the targets 29a, 29b are made of titanium. However, the material of target is not limited to above, but may be an oxide of titanium. Other suitable material of target may include metals such as aluminum (Al), silicon (Si), zirconium (Zr), tin (Sn), chromium (Cr), tantalum (Ta), tellurium (Te), iron (Fe), magnesium (Mg), hafnium (Hf), niobium (Nb), nickel-chromium (Ni-Cr), indium-tin (In-Sn), etc. The compounds of those metals, for example, Al₂O₃, SiO₂, ZrO₂, Ta₂O₅, HfO₂, etc. may also be employed.

By using metals or metal compounds as mentioned above, it is possible to obtain an optical film or insulating film made of Al₂O₃, SiO₂, ZrO₂, Ta₂O₅, SiO₂, Nb₂O₅, HfO₂, MgF₂, etc., conductor film made of ITO, magnetic film of Fe₂O₃, ultra-hard film of TiN, CrN or TiC by applying plasma processing to the metals or metal compounds in the reactive processing zone 60. For metal compounds which are rather insulating such as TiO₂, ZrO₂, SiO₂, Nb₂O₅, Ta₂O₅, etc., the sputtering speed is extremely low, as compared with metals (Ti, Zr, Si). Thus, those metal compounds are particularly suitable for the plasma processing by a thin-film forming apparatus constructed according to the invention.

(1) In the above embodiment, the targets 29a, 29b are made of the same material. However, they may be made of different materials. When the two targets are made of the same metal, a film is formed which is made of an incomplete reaction product of the metal as described above. When the two targets are made of different metals, a film is formed which is made of an incomplete reaction product of alloy.

### INDUSTRIAL APPLICABILITY

According to a thin-film forming apparatus of the invention, it is possible to form a thin-film while elevating the relative density of radicals in plasma of reactive gas to a certain degree and bringing a certain fraction of ions into contact with the thin-film.

## Claims

1. A thin-film forming apparatus comprising a vacuum chamber with an opening, a plasma generating means disposed at a position corresponding to the opening of the vacuum chamber for producing plasma in the vacuum chamber, a for holding a base plate in the vacuum chamber, and an ion quenching means disposed between the plasma generating means and the substrate holding means for quenching ions generated by the plasma generating means, wherein, when the plasma generating means are projected directly onto the substrate holding means, the projection image of plasma generating means shielded by the ion quenching means has an area smaller than the residual image of plasma generating means projected onto the substrate holding means.

2. The thin-film forming apparatus as described in Claim 1 wherein the ion quenching means is constituted of an electric conductor and is installed in the vacuum chamber being grounded.

3. The thin-film forming apparatus as described in Claim 1 wherein the ion quenching means is made of a hollow member.

4. The thin-film forming apparatus as described in Claim 2 wherein the ion quenching means is made of a hollow member.

5. The thin-film forming apparatus as described in Claim 1 wherein the ion quenching means is made of an insulating material.

6. The thin-film forming apparatus as described in Claim 1 wherein the base plate holding means is installed in the vacuum chamber being insulated from the vacuum chamber so as to float in terms of electric potential.

7. The thin-film forming apparatus as described in Claim 1 wherein the plasma generating means is connected to an RF power source, comprises an antenna in the form of a planar spiral, and is supplied power not less than 2 kW but not more than 4 kW from the RF power source.
